# EUROPÄISCHE PATENTANMELDUNG

(11) **EP 0 902 299 A2**
(43) Veröffentlichungstag der Anmeldung: **17.03.1999**
(21) Anmeldenummer: 98202989.4
(22) Anmeldetag: 07.09.1998
(51) Int. Cl.: G01R 33/62

(54) **MR-Gerät für Overhauser-Abbildungsverfahren**

(30) Priorität: 13.09.1997 DE 19740375
(71) Anmelder: Philips Patentverwaltung GmbH, 20097 Hamburg (DE); Koninklijke Philips Electronics N.V., 5621 BA Eindhoven (NL)
(72) Erfinder: Leussler, Christoph Günther, Röntgenstrasse 24, 22335 Hamburg (DE)
(74) Vertreter: Hartmann, Heinrich, Dipl.-Ing.

(57) **Zusammenfassung**

Die Erfindung betrifft ein MR-Gerät für Untersuchungen unter Ausnutzung des Overhauser Effektes und auf eine dafür geeignete Spulenanordnung, die eine ESR-Spulenanordnung und eine MR-Spulenanordnung umfaßt. Erfindungsgemäß werden alle Leiter der MR-Spulenanordnung von wenigstens zwei Leitern der ESR-Spulenanordnung eingeschlossen. Dadurch "sieht" die ESR-Spule nicht die MR-Spule, und die Güte der MR-Spulenanordnung wird durch die ESR-Spulenanordnung kaum beeinträchtigt.

## Beschreibung

Die Erfindung betrifft ein MR-Gerät, wobei ein stationäres Magnetfeld auf einen Untersuchungsbereich einwirkt, mit einer ESR-Spulenanordnung zum Erzeugen eines Hochfrequenz-Magnetfeldes bei einer ersten Frequenz und einer bei einer zweiten Frequenz arbeitenden MR-Spulenanordnung. Außerdem bezieht sich die Erfindung auf eine für ein solches MR-Gerät geeignete Spulenanordnung.

Wenn die Elektronenspinresonanz (ESR) von in Lösungen enthaltenen freien Elektronen gesättigt und erst danach darin die Kernmagnetisierung angeregt wird, ergibt sich eine erhebliche Anhebung der Amplitude des durch die Anregung der Kernmagnetisierung erzeugten MR-Signals (MR=Magnetresonanz). Auf diese Weise ist es möglich, Bilder mit hoher Qualität auch bei niedrigen Feldstärken des stationäre Magnetfeldes zu erhalten. Dieser Effekt wird allgemein als Overhauser-Effekt bezeichnet.

Die erste Frequenz (der ESR) ist - bei gleichem stationären Magnetfeld - um einen Faktor 660 größer als die zweite Frequenz (der MR). Es ist sehr schwierig, eine einzelne Spule zu schaffen, die bei diesen beiden Frequenzen optimale Eigenschaften hat. Benutzt man hingegen für ESR und MR zwei getrennte Spulenanordnungen, muß die Wechselwirkung zwischen den Spulen in Betracht gezogen werden.

Ordnet man etwa eine MR-Spule im Innern einer ESR-Spule an, dann wird das Hochfrequenz-Magnetfeld der ESR-Spule durch die MR-Spule abgeschirmt. Aufgrund der Streukapazität zwischen den Spulenwindungen ergeben sich in der MR-Spule Mehrfachresonanzen. - Ordnet man hingegen die ESR-Spule im Innern der MR-Spule an, dann kann die Wechselwirkung zwischen den Spulen gering sein, wenn der Durchmesser der MR-Spule mehrfach so groß ist wie der der ESR-Spule - wie bei dem in J. Magn. Reson. 76, 366-370, (1988) beschriebenen MR-Gerät. Die MR-Spule hat dabei jedoch einen so großen Abstand vom Untersuchungsbereich im Innern der ESR-Spule, daß damit - zumindest für die medizinische bildgebende Diagnostik - kein brauchbares Signal/Rauschverhältnis erreicht werden kann.

Aufgabe der vorliegenden Erfindung ist es daher, ein MR-Gerät der eingangs genannten Art so zu verbessern, daß sich nur noch geringe Wechselwirkungen zwischen der ESR-Spulenanordnung und der MR-Spulenanordnung ergeben.

Diese Aufgabe wird erfindungsgemäß dadurch gelöst, daß die ESR-Spulenanordnung zumindest zwei gleichartig geformte Leiterschleifen umfaßt, die bei der Erzeugung des Hochfrequenz-Magnetfeldes von einander entsprechenden Strömen mit gleichem Umlaufsinn durchflossen werden, und daß der (bzw. die) Leiter der MR-Spulenanordnung in dem vom Hochfrequenz-Magnetfeld der ESR-Spulenanordnung im wesentlichen freien Raum zwischen den Leiterschleifen angeordnet ist (sind). Eine dafür geeignete Spulenanordnung ist in Anspruch 7 angegeben.

Die Erfindung basiert auf folgender Überlegung: Bei einer ESR-Spulenanordnung aus mehreren gleichartig geformten Leiterschleifen, die von einander entsprechenden Strömen mit gleichem Umlaufsinn durchflossen werden, gibt es in deren Zentrum einen Bereich, in dem sich die Hochfrequenz-Magnetfelder der Leiterschleifen der ESR-Spulen praktisch kompensieren. Umgekehrt haben die mit den in diesem Bereich befindlichen Leitern der MR-Spulenanordnung verknüpften Magnetfelder auf die ESR-Spulenanordnung keinen Einfluß. Die ESR-Spulenanordnung "sieht" also die MR-Spulenanordnung nicht. Andererseits wirken die Leiterschleifen der ESR-Spulenanordnung auf die MR-Spulenanordnung wie eine Abschirmung, die jedoch relativ offen ist, so daß die Güte der MR-Spulenanordnung dadurch nur relativ geringfügig reduziert wird. Wenn sehr viele gleichartig geformte Leiterschleifen vorgesehen sind, ergibt sich die Wirkung eines Faraday-Käfigs.

Die in Anspruch 2 angegebene Ausgestaltung mit (zumindest) vier Leiterschleifen hat gegenüber einer Anordnung mit nur zwei Leiterschleifen den Vorteil, daß der Bereich in dem die MR-Spulenanordnung die ESR-Spulenanordnung nur geringfügig beeinflußt größer ist.

Durch die Ausgestaltung nach Anspruch 3 wird ein einwandfreies Funktionieren der ESR-Spulenanordnung auch dann sichergestellt, wenn die Länge der ESR-Spule ein Viertel der Wellenlänge der ESR-Schwingung - oder mehr - beträgt. Voraussetzung ist, daß die Länge der durch die Verbindungskondensatoren galvanisch voneinander getrennten Leiterabschnitte klein ist im Vergleich zu einem Viertel der Wellenlänge der ESR-Schwingung.

Die gemäß Anspruch 4 vorgesehene Überbrückungsglieder stellen einerseits sicher daß die Ströme in allen Leiterschleifen der ESR-Spulenanordnung gleichphasig bleiben. Andererseits werden Wirbelströme, die von der MR-Spulenanordnung oder den zur Bildgebung erforderlichen Gradientenspulen hervorgerufen werden gedämpft.

Wenn die Leiter der MR-Spulenanordnung jeweils zwischen mindestens zwei gleichartig geformten Leiterschleifen der ESR-Spulenanordnung liegen, liegt es nahe, daß beide Spulenanordnungen vom gleichen Typ sind. Gemäß Anspruch 5 kann die MR-Spulenanordnung aber auch eine oder mehrere Sattelspulen enthalten, während die ESR-Spulenanordnung vom sogenannten Birdcage-Typ ist, bei dem zwei kreisförmige Leiterabschnitte über gerade Leiterabschnitte miteinander verbunden sind. Bei der dabei möglichen weiteren Ausgestaltung nach Anspruch 6 schließen die geraden Leiterabschnitte der ESR-Spule zwischen sich die Leiter zweier (oder mehrerer) MR-Spulen ein.

Die Erfindung wird nachstehend anhand der Zeichnungen näher erläutert. Es zeigen:
Fig. 1 ein erfindungsgemäßes MR-Gerät in schematischer Darstellung,
Fig. 2 eine erste Ausführungsform einer dafür geeigneten Kombination aus ESR-und MR-Spulenanordnung,
Fig. 3 eine Einzelheit dieser Ausführungsform,
Fig. 4 eine zweite Ausführungsform in Richtung parallel zur Symmetrieachse,
Fig. 5 eine ausschnittsweise Darstellung dieser Ausführungsform in Richtung senkrecht zur Symmetrieachse und
Fig. 6 eine Einzelheit dieser zweiten Ausführungsform.

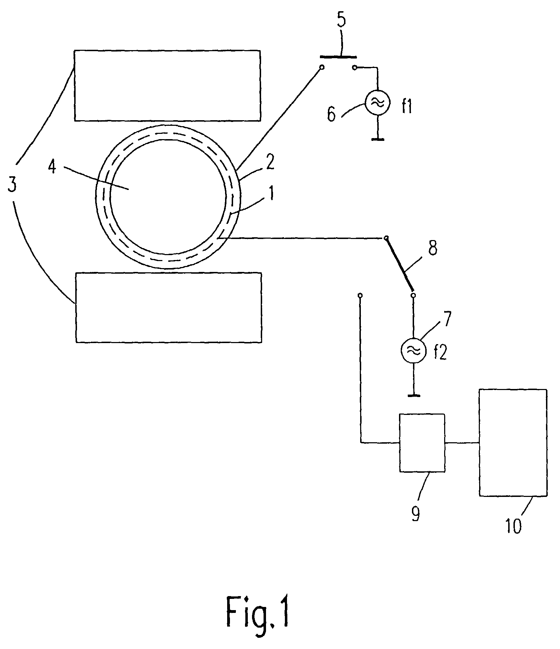

Das in Fig. 1 rein schematisch dargestellte MR-Gerät für MR-Untersuchungen unter Ausnutzung des Overhauser Effektes enthält einen Magneten 3 zur Erzeugung eines homogenen, stationären Magnetfeldes in einem Untersuchungsbereich in dem sich ein zu untersuchendes Objekt 4 z.B. der Schädel eines Patienten befinden kann. Wegen der Ausnutzung des Overhauser Effektes kann die Feldstärke des stationären Magntfeldes wesentlich geringer sein, als sonst bei MR-Geräten üblich, z.B. 15 mT. Auf den Untersuchungsbereich wirkt außerdem eine in Fig. 1 nur schematisch dargestellte Kombination aus einer MR-Spulenanordnung 1 (gestrichelt angedeutet) und einer ESR-Spulenanordnung 2 ein. Eine erste Hochfrequenz-Stromquelle 6 liefert über einen Schalter 5 an die ESR-Spulenanordnung 2 einen Hochfrequenzstrom mit einer ersten Frequenz f₁ = 226 Mhz, während eine zweite Hochfrequenz-Stromquelle 7 der MR-Spulenanordnung 1 über einen Umschalter 8 einen Hochfrequenzstrom mit einer zweite Frequenz f₂ = 600 kHz liefert.

Über den Umschalter 8 kann die MR-Spulenanordnung 1 mit einem Spektrometer 9 verbunden werden, das die empfangenen MR-Signale für eine Rekonstruktionseinheit 10 aufbereitet, die daraus ein MR-Bild des Untersuchungsbereiches rekonstruiert.

Bei einer Untersuchung wird zunächst mittels der ESR-Spulenanordnung 2 die Elektronenspinresonanz von freien Elektronen gesättigt, die in einer in das Objekt 4 injizierten Lösung enthalten sind. Danach wird die Kernmagnetisierung im Untersuchungsbereich durch die MR-Spulenanordnung 1 angeregt, wonach der Umschalter 8 umgeschaltet wird und die von der MR-Spulenanordnung empfangenen MR-Signale von dem Spektrometer 9 verarbeitet werden.

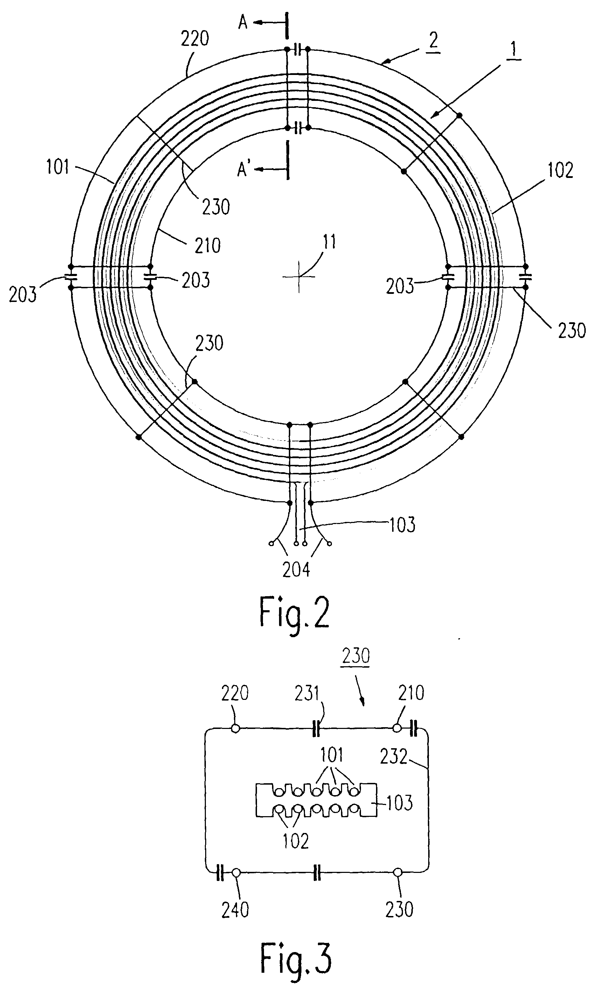

Die Figuren 2 und 3 zeigen eine erste Ausführungsform der Kombination der Spulenanordnungen 1,2, wobei Fig. 3 eine Ansicht des in Fig. 2 durch die Linien A-A' definierten Querschnitts darstellt. Die MR-Spulenanordnung 1 besteht aus einer Spule, deren Windungen 101 in einer ersten Ebene von spiralförmig von außen nach innen gewickelt sind und dessen Windungen 102 (in Fig. 2 mit dünnen Linien dargestellt) in einer zweiten Ebene von innen nach außen auf einen Wickelkörper 103 gewickelt sind. Die Eingangsanschlüsse dieser MR-Spule sind mit 104 bezeichnet. Die MR-Spule kann aus einer geeigneten Kupferlitze hergestellt sein, um die erforderliche Güte zu erreichen.

Die ESR-Spule 2 weist in einer Ebene oberhalb der MR-Spule zwei konzentrisch zur Symmetrieachse 11 angeordnete kreisförmige Leiterschleifen 210 und 220 auf und in einer zweiten, unterhalb der MR-Spule 1 befindlichen Ebene (die beiden Ebenen können durch die Oberfläche von zwei nicht dargestellten Trägerkörpern definiert sein) zwei konzentrisch angeordnete Leiterschleifen 230 und 240. Die vier Leiterschleifen 210...240 bilden somit im Querschnitt ein Rechteck, in dessen praktisch feldfreien Zentrum sich die MR-Spule befindet. Deshalb hat die MR-Spule 1 auf die ESR-Spule 2 praktisch keinen Einfluß.

Die Leiterschleifen 210...240 sind längs des Umfangs in regelmäßigen Abständen unterbrochen, so daß voneinander galvanisch getrennte Leiterabschnitte entstehen, die kurz sind im Vergleich zu einem Viertel der Wellenlänge bei der Frequenz f₁. Diese Leiterabschnitte sind über Kondensatoren 203 miteinander verbunden, deren Kapazität so gemessen ist, daß jede der Leiterschleifen bei der Frequenz f₁ in Resonanz ist.

Um die Wechselwirkung zwischen der ESR-Spule und der MR-Spule klein zu halten, müssen die Ströme in den vier Leiterschleifen entlang des Umfangs jeweils die gleiche Phasenlage aufweisen. Um dies sicherzustellen, sind die verschiedenen Leiterschleifen 210...240 in regelmäßigen Abständen - z.B. vor und hinter den Unterbrechungen, sowie in der Mitte dazwischen - durch Überbrückungsglieder 230 überbrückt. Die vier durch die Überbrückungsglieder parallel geschaltenen Leiterschleifen bilden eine ESR-Spule mit einer einzigen Windung, deren Eingangsanschlüsse mit 204 bezeichnet sind.

Die Überbrückungsglieder 230 sind in Fig. 2 durch eine fette Linie angedeutet, jedoch können sie, wie aus Fig. 3 ersichtlich, neben einem Leiter 232 einen Kondensator 231 enthalten. Dessen Kapazität ist so bemessen, daß die Überbrückungsglieder für die Frequenz f₁ einen Kurzschluß darstellen und für die Frequenz f₂ eine relativ hohe Impedanz, die die von der MR-Spule - oder den zur Bildgebung erforderlichen Gradientenspulen - hervorgerufenen Wirbelströme in der ESR-Spule dämpft. Dabei muß nicht jedes Überbrückungsglied einen Kondensator 231 enthalten, wie in Fig. 3 dargestellt. Jedoch muß in jeder aus zwei Leitern und den sie verbindenden Überbrückungsgliedern 230 bestehenden Schleife mindestens ein Kondensator vorhanden sein; anderenfalls würden die von der MR-Spulenanordnung 1 erzeugten Wirbelströme in diesen Maschen die Güte der MR-Spule deutlich reduzieren.

Es können zur Untersuchung auch mehrere der in Fig. 2 dargestellten Spulenanordnungen verwendet werden, wobei die empfangenen MR-Signale getrennt verarbeitet und zu einem einzigen MR-Bild kombiniert werden können.

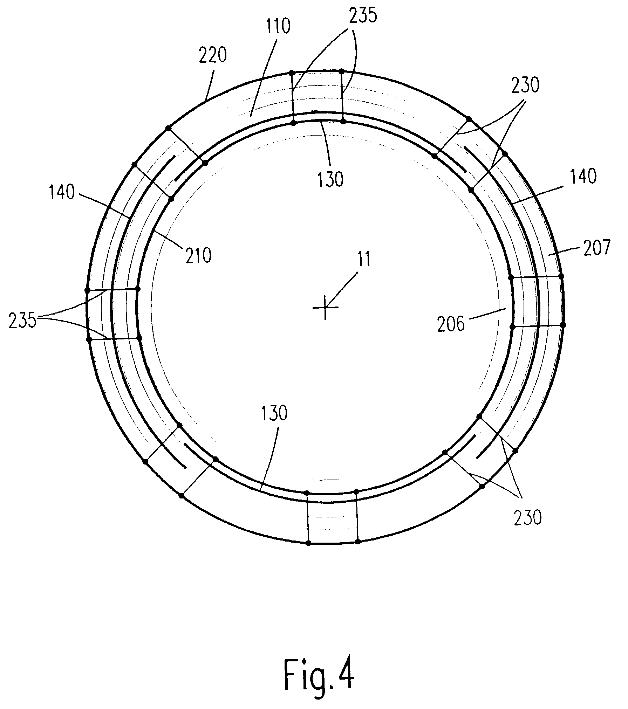

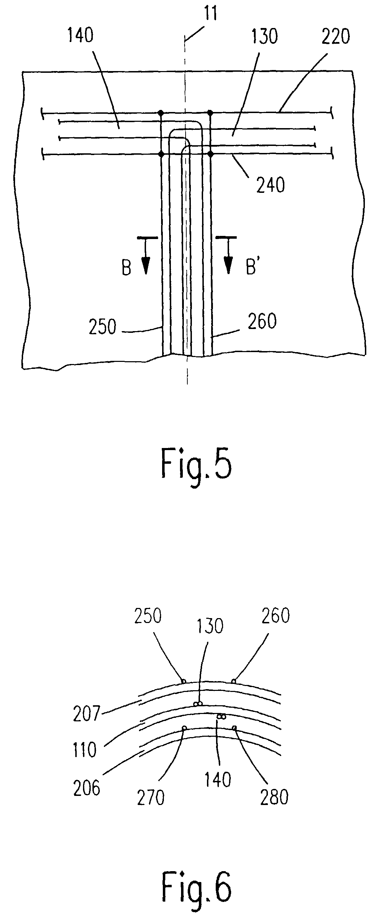

In den Figuren 4 bis 6 ist eine andere Ausführungsform der Erfindung dargestellt. Während bei der ersten Ausführungsform die Leiter der MR- bzw. der ESR-Spule in einer bzw. zwei Ebenen angeordnet sind, handelt es sich bei dieser zweiten Ausführungsform um eine (zylinderförmige) Volumenspulenanordnung, die einen dreidimensionalen Untersuchungsbereich einschließen kann. Fig. 4 stellt dabei eine Stirnansicht (in Richtung der Zylinderachse 11 gesehen) dar, während Fig. 5 eine - ausschnittsweise - Darstellung einer Draufsicht (senkrecht zur Zylinderachse 11) ist. Fig. 6 stellt die Spulenanordnung ausschnittsweise in einem zur Symmetrieachse 11 senkrechten Querschnitt dar, der durch die Pfeile B - B' in Fig. 5 definiert ist.

Die MR-Spulenanordnung umfaßt zwei um 90° gegeneinander versetzte Sattelspulen 130,140, die als Quadraturspulen betrieben werden können und von denen die Sattelspule 140 auf der Außenfläche eines isolierenden Trägerkörpers 110, z.B. aus Kunststoff, angebracht ist, während die Sattelspule 130 mit der Innenfläche des Trägerkörpers verbunden ist.

Die Sattelspulen haben einen die Zylinderachse 11 umschließenden bogenförmigen Teil und einen zur Zylinderachse parallel verlaufenden Teil. Fig. 5 zeigt darüberhinaus, daß jede Sattelspule 130, 140 mehrere Windungen (Fig. 5 zeigt nur zwei Windungen) aufweist, die sich mit den Windungen der anderen Spulen mehr oder weniger überlappen.

Zur ESR-Spulenanordnung gehört ein zylinderförmiger Trägerkörper 206, der von dem Trägerkörper 110 umschlossen wird und ein Trägerkörper 207, der den Trägerkörper 110 umschließt. Auf dem vorderen Teil der Trägerkörper 206, 207 befinden sich - in axialer Richtung gegeneinander versetzt - zwei Leiterschleifen 210 und 230 (letztere nicht dargestellt), und ebenso befinden sich auf dem Trägerkörper 207 zwei in axialer Richtung gegeneinander versetzte Leiterschleifen 220 und 240 (vgl. Fig. 5). Die vier ringförmigen Leiterschleifen schließen die bogenförmigen Abschnitte der Sattelspulen ein. Die Bögen am anderen Ende der Sattelspule werden auf gleiche Weise von nicht näher dargestellten Leiterschleifen der ESR-Spule eingeschlossen.

Die Leiterschleifen 210...240 sind in gleicher Weise wie bei den in Fig. 2 und 3 dargestellten Ausführungsbeispiel durch nicht näher dargestellte Verbindungskondensatoren unterbrochen, so daß sich Leiterschleifenabschnitte ergeben, die kürzer sind als 1/4 der Wellenlänge der ESR-Frequenz.

Beiderseits der vier auf dem Umfang gegeneinander versetzten Bereiche, in denen sich die Sattelspulen 130, 140 überlappen, sind Überbrückungsglieder 230 vorgesehen (Fig.4). Auch die sich geradlinig erstreckenden Abschnitte der Sattelspulen werden von zwei geradlinigen Leiterschleifen 250, 260 auf den äußeren Trägerkörper 207 und 270, 280 auf dem inneren Trägerkörper 206 eingeschlossen, wie sich aus Fig. 5 und insbesondere Fig. 6 ergibt. Somit sind alle Teile der beiden Sattelspulen von je vier Leiterschleifen der ESR-Spulenanordnung eingeschlossen.

Durch die ringförmigen Leiterschleifen der ESR-Spulenanordnung an den Stirnseiten und durch die sie verbindenden geradlinigen Leiterschleifen 250...280 ergibt sich eine ESR-Spule vom sogenannten Birdcage-Typ, wobei jedoch alle Leiter vierfach vorhanden sind. Allerdings hätte eine solche Birdcage-Spule nur vier auf dem Umfang um 90° gegeneinander versetzte stabförmige Leiterschleifen. Um eine verbesserte Empfindlichkeit der ESR-Spule zu erreichen, können vier weitere derartiger stabförmiger Leiterschleifen (nicht dargestellt) vorgesehen sein, die gegenüber den Überlappungsbereichen um jeweils 45° versetzt sind und die die dort vorgesehenen zusätzlichen Überbrückungsglieder 235 an deren Enden senkrecht zur Zeichenebene der Fig. 4 fortsetzen.

Anstelle der in der Zeichnung dargestellten kreisförmigen Spulen können auch anders geformte Spulen - z.B rechteckig oder elliptische - benutzt werden. Bei dem Ausführungsbeispiel nach Fig. 1 fungiert die MR-Spule als Sende- und als Empfangsspule. Es kann aber auch eine gesonderte MR-Spule als Sende-Spule benutzt werden, welche die in den Zeichnungen dargestellte Spulenanordnung umschließt, z.B. eine Sattelspule. Mit einer Kühlung zumindest der MR-Empfangsspule - z.B mit flüssigem Stickstoff - kann das Signal/Rauschverhältnis verbessert werden.

## Patentansprüche

1. MR-Gerät, wobei ein stationäres Magnetfeld auf einen Untersuchungsbereich einwirkt, mit einer ESR-Spulenanordnung (2) zum Erzeugen eines Hochfrequenz-Magnetfeldes bei einer ersten Frequenz und einer bei einer zweiten Frequenz arbeitenden MR-Spulenanordnung (1),
dadurch gekennzeichnet, daß die ESR-Spulenanordnung (2) zumindest zwei gleichartig geformte Leiterschleifen (210, 220) umfaßt, die bei der Erzeugung des Hochfrequenz-Magnetfeldes von einander entsprechenden Strömen mit gleichem Umlaufsinn durchflossen werden, und daß der (bzw die) Leiter der MR-Spulenanordnung (101,102) in dem vom Hochfrequenz-Magnetfeld der ESR-Spulenanordnung (2) im wesentlichen freien Raum zwischen den Leiterschleifen angeordnet ist (sind).

2. MR-Gerät nach Anspruch 1,
dadurch gekennzeichnet, daß die ESR-Spulenanordnung (2) zumindest vier Leiterschleifen (210.....240) umfaßt.

3. MR-Gerät nach Anspruch 1,
dadurch gekennzeichnet, daß die Leiterschleifen (210, 220) der ESR-Spulenanordnung aus Leiterabschnitten bestehen, die über Verbindungs-Kondensatoren (203) elektrisch miteinander verbunden sind.

4. MR-Gerät nach Anspruch 1,
dadurch gekennzeichnet, daß einander benachbarte Leiterschleifen (210, 220) der ESR-Spulenanordnung durch Überbrückungsglieder überbrückt sind, die ein Leiterstück (231) und/oder einen Überbrückungs-Kondensator (232) enthalten, daß die durch Teile zweier Leiterschleifen (210, 220) und durch zwei Überbrückungsglieder (230) gebildeten Maschen mindestens einen Überbrückungskondensator (232) umfassen, und daß die Kapazität der Überbrückungskondensatoren so bemessen ist, daß sie eine niedrige Impedanz für die erste Frequenz und eine zur Dämpfung von Wirbelströmen der zweiten Frequenz hinreichend große Impedanz aufweisen.

5. MR-Gerät nach Anspruch 1,
dadurch gekennzeichnet, daß die MR-Spulenanordnung (1) mindestens eine Sattelspule (130, 140) aufweist mit eine Achse (11) bogenförmig umgebenden Segmenten, die über zur Achse parallele Segmente miteinander verbunden sind und daß die ESR-Spulenanordnung (2) vom Birdcage-Typ ist, deren kreisförmige Leiterabschnitte (210.....24) die bogenförmigen Segmente und deren gerade Leiterabschnitte (250....280) die parallelen Segmente der MR-Spulenanordnung einschließen.

6. MR-Gerät nach Anspruch 5,
dadurch gekennzeichnet, daß die MR-Spulenanordnung mehrere gegeinander versetzte und den gleichen Abschnitt (11) der Achse umschließende Sattelspulen (130) umfaßt und daß die geraden Leiterabschnitte (250....280) der ESR-Spulenanordnung je ein zur Achse paralleles Segment von wenigstens zwei Sattelspulen (130, 140) einschließen.

7. Spulenanordnung mit einer ESR-Spulenanordnung (2) zum Erzeugen eines Hochfrequenz-Magnetfeldes bei einer ersten Frequenz und einer bei einer zweiten Frequenz arbeitenden MR-Spulenanordnung (1),
dadurch gekennzeichnet, daß die ESR-Spulenanordnung (2) zumindest zwei gleichartig geformte Leiterschleifen (210, 220) umfaßt, die bei der Erzeugung des Hochfrequenz-Magnetfeldes von einander entsprechenden Strömen mit gleichem Umlaufsinn durchflossen werden, und daß der (bzw die) Leiter der MR-Spulenanordnung (101,102) in dem vom Hochfrequenz-Magnetfeld der ESR-Spulenanordnung (2) im wesentlichen freien Raum zwischen den Leiterschleifen angeordnet ist (sind).
